# EUROPÄISCHE PATENTSCHRIFT

(11) **EP 2 591 511 B1**
(45) Veröffentlichungstag und Bekanntmachung des Hinweises auf die Patenterteilung: **31.10.2018**
(21) Anmeldenummer: 11743203.9
(22) Anmeldetag: 01.07.2011
(51) Int. Cl.: H01L 33/44, H01L 33/62, H01L 33/56, H01L 33/48, H01L 33/60, H01L 33/52, H01L 33/54

(54) **BAUELEMENT UND VERFAHREN ZUR HERSTELLUNG EINES BAUELEMENTS**
COMPONENT AND METHOD FOR PRODUCING A COMPONENT
COMPOSANT ET PROCÉDÉ DE PRODUCTION D'UN COMPOSANT

(30) Priorität: 07.07.2010 DE 102010026343
(43) Veröffentlichungstag der Anmeldung: 15.05.2013
(73) Patentinhaber: OSRAM Opto Semiconductors GmbH, 93055 Regensburg (DE)
(72) Erfinder: RAMCHEN, Johann, 93077 Bad Abbach (DE); SORG, Jörg Erich, 93053 Regensburg (DE); JEREBIC, Simon, 93105 Tegernheim (DE); BRAUNE, Bert, 93173 Wenzenbach (DE)
(74) Vertreter: Epping - Hermann - Fischer
(86) Internationale Anmeldenummer: PCT/EP2011/061133
(87) Internationale Veröffentlichungsnummer: WO 2012/004202

(56) Entgegenhaltungen:
- EP-A2- 1 385 217
- WO-A2-2004/032249
- DE-A1- 4 232 637
- DE-A1-102007 029 369
- JP-A- 2004 241 704
- JP-A- 2006 269 986
- US-A1- 2007 126 019

## Beschreibung

Die vorliegende Anmeldung betrifft ein Bauelement mit einem optoelektronischen Halbleiterchip und ein Verfahren zur Herstellung eines solchen Bauelements.

Zur Herstellung von oberflächenmontierbaren optoelektronischen Bauelementen wie beispielsweise oberflächenmontierbaren Leuchtdioden können Halbleiterchips in einem Gehäuse befestigt und zum Schutz des Halbleiterchips mit einer Umhüllung versehen werden.

Mechanische Spannungen können bewirken, dass sich die Befestigung des Halbleiterchips löst, was zu einem vorzeitigen Ausfall des Bauelements führen kann.

Die Druckschrift EP 1 385 217 A2 betrifft eine Halbleiterleuchte, bei der ein LED-Chip in einem Kunststoffgehäuse angebracht ist.

Aus den Druckschriften JP 2006-269986 A und DE 10 2007 029 369 A1 sind LED-Bauteile bekannt, bei denen ein LED-Chip in einem Gehäuse mit einem mehrlagigen Verguss versehen ist.

Radial-LED-Bauformen finden sich in den Druckschriften US 2007/0126019 A1 und DE 42 32 367 A1.

Eine Silikon-basierte Pufferschicht in einem LED-Gehäuse ist in der Druckschrift JP 2004-424704 A offenbart.

Gemäß der Druckschrift WO 2004/032249 A2 ist ein LED-Chip in einer Ausnehmung in einem Gehäusekörper angebracht.

Eine Aufgabe ist es, ein Bauelement anzugeben, das im Betrieb eine erhöhte Zuverlässigkeit aufweist. Weiterhin soll ein Verfahren angegeben werden, mit dem ein solches Bauelement einfach und zuverlässig hergestellt werden kann.

Diese Aufgabe wird durch den Gegenstand der unabhängigen Patentansprüche gelöst. Ausgestaltungen und Weiterbildungen sind Gegenstand der abhängigen Patentansprüche.

Erfindungsgemäß weist ein Bauelement einen optoelektronischen Halbleiterchip auf, der mit einer Verbindungsschicht auf einem Anschlussträger befestigt ist und in eine Umhüllung eingebettet ist. Zwischen der Verbindungsschicht und der Umhüllung ist zumindest bereichsweise eine Entkopplungsschicht angeordnet.

Mittels der Entkopplungsschicht werden die Verbindungsschicht und die Umhüllung mechanisch voneinander entkoppelt. Die Gefahr, dass mechanische Spannungen, insbesondere Zugspannungen, im Bauelement zu einem Ablösen des Halbleiterchips führen, ist dadurch weitgehend vermindert. Die Entkopplungsschicht ist also derart ausgebildet, dass in der Umhüllung auftretende Spannungen nicht oder nur zu einem verringerten Anteil auf die Verbindungsschicht übertragen werden.

Die Umhüllung kann die Entkopplungsschicht in Aufsicht auf das Bauelement insbesondere vollständig überdecken.

Weiterhin sind mittels der Entkopplungsschicht die Anforderungen an die Elastizität der Umhüllung verringert. Für die Umhüllung kann daher auch ein Material mit einem vergleichsweise hohen Elastizitätsmodul Anwendung finden, ohne dass hierdurch die mechanische Stabilität der Verbindung zwischen Halbleiterchip und Anschlussträger gefährdet wird. Erfindungsgemäß enthält die Umhüllung ein Epoxid mit einem Elastizitätsmodul von 2GPa oder mehr.

Die Entkopplungsschicht weist einen geringeren Elastizitätsmodul auf als die Umhüllung. Je geringer der Elastizitätsmodul ist, desto weniger Widerstand setzt ein Material seiner Verformung entgegen.

Das Material für die Entkopplungsschicht weist erfindungsgemäß einen Elastizitätsmodul von höchstens 1 GPa, besonders bevorzugt von höchstens 200 kPa, auf.

Erfindungsgemäß enthält die Entkopplungsschicht ein Material, dessen Glasübergangstemperatur T_{G} bei Raumtemperatur oder niedriger liegt. Bei Temperaturen oberhalb der Glasübergangstemperatur befinden sich organische oder anorganische Gläser in einem energieelastischen Bereich, in dem sie sich durch eine hohe Verformbarkeit auszeichnen. Vorzugsweise enthält die Entkopplungsschicht ein Material aus der Gruppe der Materialgruppen bestehend aus Elastomer, Harz, Silikonharz, Silikon, Silikongel, Polyurethan, Gummi.

In einer bevorzugten Ausgestaltung sind in die Entkopplungsschicht Partikel eingebettet. Mittels der Partikel kann die Dichte der Entkopplungsschicht erhöht werden. Dies kann eine geringere thermische Auswirkung der Entkopplungsschicht bewirken. Die Gefahr einer Spannungsübertragung auf die Verbindungsschicht wird hierdurch weitergehend vermindert.

Weiterhin sind mittels der Partikel die optischen Eigenschaften der Entkopplungsschicht einstellbar.

In einer nicht zur Erfindung gehörigen Ausgestaltungsvariante ist die Entkopplungsschicht für die vom Halbleiterchip im Betrieb erzeugte oder zu detektierende Strahlung reflektierend ausgebildet. In diesem Fall können in die Entkopplungsschicht Partikel eingebettet sein, die die Strahlung, insbesondere diffus, reflektieren. Beispielsweise kann durch Zugabe von Titandioxidpartikeln eine Reflektivität im sichtbaren Spektralbereich von 85 % oder mehr, beispielsweise von 95 %, erzielt werden.

Erfindungsgemäß ist die Entkopplungsschicht für die vom Halbleiterchip im Betrieb emittierte Strahlung gezielt absorbierend ausgebildet. Unter gezielt absorbierend wird insbesondere verstanden, dass die Strahlung beim Auftreffen auf die Entkopplungsschicht zu einem Anteil von mindestens 80 % absorbiert wird. Insbesondere kann die Entkopplungsschicht für das menschliche Auge schwarz ausgebildet sein. Mittels einer solchen Entkopplungsschicht kann bei einem strahlungsemittierenden Bauelement ein erhöhter Kontrast zwischen ausgeschaltetem Zustand und eingeschaltetem Zustand erzielt werden. Für eine absorbierende Entkopplungsschicht eignen sich beispielsweise Ruß-Partikel.

In einer bevorzugten Ausgestaltung überdeckt die Entkopplungsschicht in Aufsicht auf das Bauelement einen über den Halbleiterchip hinausragenden Teil der Verbindungsschicht zumindest teilweise, bevorzugt vollständig. Durch eine vollständige Überdeckung ist gewährleistet, dass die Umhüllung und die Verbindungsschicht an keiner Stelle des Bauelements unmittelbar aneinander angrenzen.

Erfindungsgemäß grenzt die Entkopplungsschicht unmittelbar an den Halbleiterchip an. Die Entkopplungsschicht umläuft den Halbleiterchip in lateraler Richtung, also entlang einer Haupterstreckungsebene der Halbleiterschichten des optoelektronischen Halbleiterchips verlaufenden Richtung,.

Das Bauelement ist als ein oberflächenmontierbares Bauelement (surface mounted device, SMD) ausgeführt. Weiterhin weist das Bauelement einen Gehäusekörper auf. Der Gehäusekörper weist eine Kavität auf, in der der Halbleiterchip angeordnet ist. Weiterhin ist der Anschlussträger als ein Teil eines Leiterrahmens ausgestaltet, an den ein Gehäusegrundkörper des Gehäusekörpers angeformt ist.

In einer bevorzugten Weiterbildung ist eine Bodenfläche der Kavität in Aufsicht auf das Bauelement vollständig von der Entkopplungsschicht bedeckt. Mit anderen Worten kann eine an die Bodenfläche angrenzende Seitenfläche der Kavität die Entkopplungsschicht in lateraler Richtung begrenzen.

Der Halbleiterchip überragt die Entkopplungsschicht in einer vertikalen Richtung. So ist auf einfache Weise gewährleistet, dass eine dem Anschlussträger abgewandte Oberseite des Halbleiterchips frei von der Entkopplungsschicht ist.

Bei einem Verfahren zur Herstellung eines Bauelements mit einem optoelektronischen Halbleiterchip wird ein Anschlussträger bereitgestellt. Der Halbleiterchip wird mittels einer Verbindungsschicht auf dem Anschlussträger befestigt. Eine Entkopplungsschicht wird auf die Verbindungsschicht aufgebracht. Auf die Entkopplungsschicht wird eine Umhüllung aufgebracht, wobei der Halbleiterchip in die Umhüllung eingebettet wird.

Mittels der Entkopplungsschicht kann die Umhüllung so aufgebracht werden, dass mechanische Spannungen in dem Bauelement die Verbindung zwischen dem Halbleiterchip und dem Anschlussträger nicht oder zumindest nicht wesentlich gefährden können.

In einer bevorzugten Ausgestaltung wird die Entkopplungsschicht mittels eines Dispensers aufgebracht. Alternativ oder ergänzend kann ein anderes Dosier- und Füllverfahren Anwendung finden, beispielsweise Gießen, Spritzen, Spritzpressen oder Drucken.

Das beschriebene Verfahren ist für die Herstellung eines weiter oben beschriebenen Bauelements besonders geeignet.

Weitere Merkmale, Ausgestaltungen und Zweckmäßigkeiten ergeben sich aus der folgenden Beschreibung der Ausführungsbeispiele in Verbindung mit den Figuren.

Es zeigen:
- Figur 1: ein erstes Ausführungsbeispiel für ein Bauelement in schematischer Schnittansicht,
- Figur 2: ein zweites Ausführungsbeispiel für ein Bauelement in schematischer Schnittansicht,
- Figur 3: ein Ausführungsbeispiel für einen optoelektronischen Halbleiterchip für ein Bauelement, und
- die Figuren 4A bis 4C: ein Ausführungsbeispiel für ein Verfahren zur Herstellung eines Bauelements anhand von jeweils in schematischer Schnittansicht dargestellten Zwischenschritten.

Gleiche, gleichartige oder gleich wirkende Elemente sind in den Figuren mit denselben Bezugszeichen versehen.

Die Figuren und die Größenverhältnisse der in den Figuren dargestellten Elemente untereinander sind nicht als maßstäblich zu betrachten. Vielmehr können einzelne Elemente zur verbesserten Darstellbarkeit und/oder zum besseren Verständnis übertrieben groß dargestellt sein.

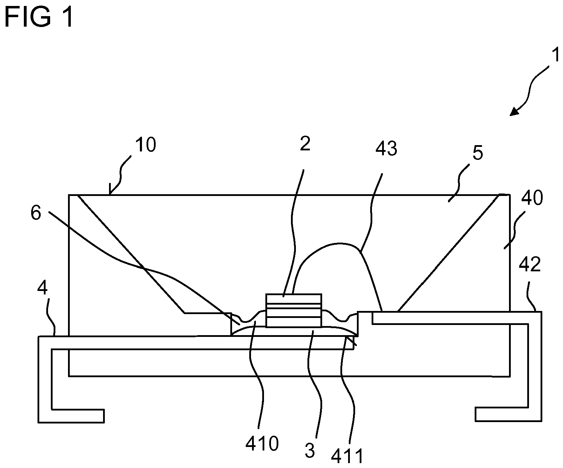

Ein erstes Ausführungsbeispiel für ein Bauelement ist in Figur 1 in schematischer Schnittansicht dargestellt. Das Bauelement 1 weist einen optoelektronischen Halbleiterchip 2 auf, der mittels einer Verbindungsschicht 3 an einem Anschlussträger 4 befestigt ist. Für die Verbindungsschicht 3 eignet sich insbesondere eine Klebeschicht. Es kann aber auch eine Lotschicht Anwendung finden.

Der Anschlussträger 4 und ein weiterer Anschlussträger 42 bilden einen Leiterrahmen für das optoelektronische Bauelement 1. Ein Gehäusekörper 40 ist an den Leiterrahmen angeformt.

Das Bauelement 1 ist als ein oberflächenmontierbares Bauelement ausgeführt, das mittels des Anschlussträgers 4 und des weiteren Anschlussträgers 42 von der der Strahlungsdurchtrittsfläche 10 abgewandten Seite her extern elektrisch kontaktierbar ist.

Der Gehäusekörper 40 weist eine Kavität 410 auf, in der der Halbleiterchip 2 angeordnet ist. Der weitere Anschlussträger 42 ist mittels einer Verbindungsleitung 43, einer Drahtbondverbindung, mit dem Halbleiterchip 2 verbunden, sodass im Betrieb des Bauelements über den Anschlussträger 4 und den weiteren Anschlussträger 42 Ladungsträger von verschiedenen Seiten in den Halbleiterchip 2 injiziert werden oder von dem Halbleiterchip abfließen können.

Der Halbleiterchip 2 und die Verbindungsleitung 43 sind in eine Umhüllung 5 eingebettet, die den Halbleiterchip und die Verbindungsleitung vor äußeren Einflüssen wie mechanischer Belastung oder Feuchtigkeit schützt.

Die Umhüllung 5 bildet eine Strahlungsdurchtrittsfläche 10 des Bauelements.

Zwischen der Umhüllung 5 und der Verbindungsschicht 3 ist eine Entkopplungsschicht 6 angeordnet. Die Entkopplungsschicht 6 bedeckt in Aufsicht auf das Bauelement denjenigen Teil der Verbindungsschicht 3, der in lateraler Richtung, also entlang einer Haupterstreckungsebene der Halbleiterschichten des Halbleiterchips 2 über den Halbleiterchip 2 hinausragt. Die Umhüllung 5 und die Verbindungsschicht 3 grenzen somit an keiner Stelle unmittelbar aneinander an. Eine mechanische Entkopplung zwischen der Verbindungsschicht und der Umhüllung ist dadurch auf zuverlässige Weise realisiert.

Die Umhüllung 5 überdeckt die Entkopplungsschicht 6 in Aufsicht auf das Bauelement 1 vollständig.

Die Entkopplungsschicht 6 weist einen geringeren Elastizitätsmodul auf als die Umhüllung. Mechanische Spannungen im Bauelement 1 wirken somit nur zu einem verminderten Anteil auf die Verbindungsschicht 3 ein. Die Gefahr einer Ablösung des Halbleiterchips 2 von dem Anschlussträger 4, etwa an einer Grenzfläche zwischen dem Anschlussträger und der Verbindungsschicht 3, ist somit weitgehend verringert.

Die Entkopplungsschicht 6 weist einen Elastizitätsmodul von höchstens 1 GPa, besonders bevorzugt von höchstens 200 kPa, auf.

Die Entkopplungsschicht enthält ein Material, dessen Glasübergangstemperatur T_{G} bei Raumtemperatur oder niedriger liegt. Die Entkopplungsschicht enthält bevorzugt ein Material aus der Gruppe der Materialgruppen bestehend aus Elastomer, Harz, Silikonharz, Silikon, Silikongel, Polyurethan, Gummi.

Aufgrund der mechanischen Entkopplung durch die Entkopplungsschicht 6 findet für die Umhüllung 5 ein Material mit einem vergleichsweise hohen Elastizitätsmodul von 2 GPa oder mehr Anwendung. Die Umhüllung enthält ein Epoxid oder besteht aus einem Epoxid.

In vertikaler Richtung ragt der Halbleiterchip 2 über die Entkopplungsschicht 6 hinaus. Eine dem Anschlussträger 4 abgewandte Oberfläche des Halbleiterchips 2 bleibt somit frei von der Entkopplungsschicht 6.

Der Halbleiterchip 2, ein für die Emission und/oder die Detektion von Strahlung vorgesehener aktiver Bereich, enthält vorzugsweise ein III-V-Verbindungshalbleitermaterial.

III-V-Halbleitermaterialien sind zur Strahlungserzeugung im ultravioletten (AlₓIn_{y}Ga_{1-x-y}N) über den sichtbaren (AlₓIn_{y}Ga_{1-x-y}N, insbesondere für blaue bis grüne Strahlung, oder AlₓIn_{y}Ga_{1-x-y}P, insbesondere für gelbe bis rote Strahlung) bis in den infraroten (AlₓIn_{y}Ga_{1-x-y}As) Spektralbereich besonders geeignet. Hierbei gilt jeweils 0 ≤ x ≤ 1, 0 ≤ y ≤ 1 und x + y ≤ 1, insbesondere mit x ≠ 1, y ≠ 1, x ≠ 0 und/oder y ≠ 0. Mit III-V-Halbleitermaterialien, insbesondere aus den genannten Materialsystemen, können weiterhin bei der Strahlungserzeugung hohe interne Quanteneffizienzen erzielt werden.

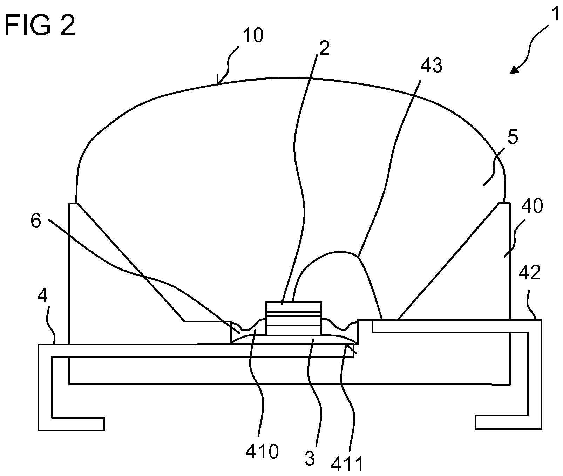

Ein zweites Ausführungsbeispiel für ein Bauelement ist in Figur 2 in schematischer Schnittansicht dargestellt. Dieses zweite Ausführungsbeispiel entspricht im Wesentlichen dem im Zusammenhang mit Figur 1 beschriebenen ersten Ausführungsbeispiel. Im Unterschied hierzu ist die Umhüllung 5 auf der dem Halbleiterchip 2 abgewandten Seite in Aufsicht auf das Bauelement konvex gekrümmt. Die Umhüllung 5 erfüllt in diesem Ausführungsbeispiel zusätzlich die Funktion einer Sammellinse für die vom Halbleiterchip im Betrieb emittierte und/oder zu empfangene Strahlung. Die Umhüllung kann hierbei einteilig oder mehrteilig ausgebildet sein. Beispielsweise ein die Linse bildender Bereich der Umhüllung nach dem Verkapseln des Halbleiterchips in einem separaten Herstellungsschritt ausgebildet sein.

Mittels der Form der Umhüllung 5 seitens der Strahlungsdurchtrittsfläche 10 ist die räumliche Abstrahlcharakteristik des Bauelements 1 einstellbar.

Weiterhin sind im Unterschied zum ersten Ausführungsbeispiel in die Entkopplungsschicht 6 Partikel 65 eingebettet. Mittels der Partikel kann die Dichte der Entkopplungsschicht eingestellt, insbesondere erhöht werden. Dadurch kann die thermische Ausdehnung der Entkopplungsschicht auf einfache Weise verringert werden.

Die Partikel 65 weisen vorzugsweise eine mittlere Größe zwischen einschließlich 200 nm und 10 µm, besonders bevorzugt zwischen einschließlich 500 nm und einschließlich 5 pm auf.

Weiterhin können die Partikel die optischen Eigenschaften der Entkopplungsschicht beeinflussen.

In einer nicht erfindungsgemäßen Ausgestaltungsvariante sind in die Entkopplungsschicht 6 reflektierende Partikel eingebettet. Beispielsweise können mit Titandioxidpartikeln Reflektivitäten im sichtbaren Spektralbereich von 85 % oder mehr, beispielsweise von 95 %, erzielt werden. Mittels einer reflektierend ausgebildeten Entkopplungsschicht kann die insgesamt aus dem Bauelement 1 austretende Strahlungsleistung erhöht werden.

Erfindungsgemäß sind in die Entkopplungsschicht Partikel eingebettet, die die Strahlung gezielt absorbieren. Beispielsweise eignen sich hierfür Ruß-Partikel.

Mittels einer gezielt absorbierend ausgeführten Entkopplungsschicht 6 kann das Kontrastverhältnis des Bauelements 1 zwischen ausgeschaltetem und eingeschaltetem Zustand erhöht werden.

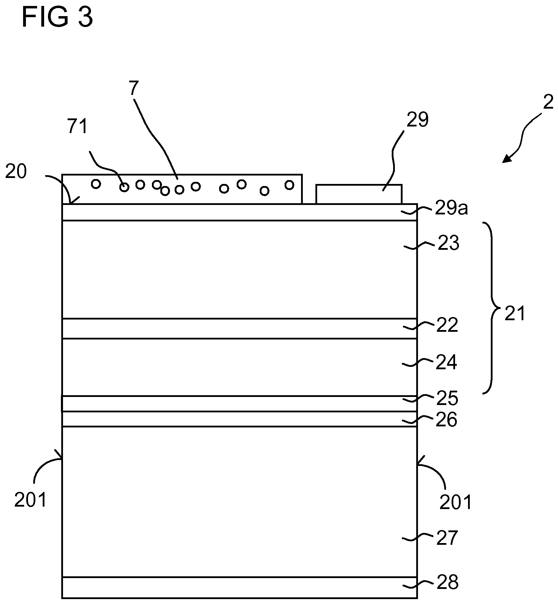

Ein Ausführungsbeispiel für einen Halbleiterchip 2, der für ein Bauelement gemäß dem ersten oder zweiten Ausführungsbeispiel besonders geeignet ist, ist in Figur 3 in schematischer Schnittansicht dargestellt.

Der Halbleiterchip 2 weist einen Halbleiterkörper 21 mit einer Halbleiterschichtenfolge auf, die den Halbleiterkörper bildet. Der Halbleiterkörper 21 ist auf einem Träger 27 angeordnet, der von einem Aufwachssubstrat für die Halbleiterschichten des Halbleiterkörpers 21 verschieden ist. Der Träger dient der mechanischen Stabilisierung des Halbleiterkörpers 21. Das Aufwachssubstrat ist hierfür nicht mehr erforderlich. Ein Halbleiterchip, bei dem das Aufwachssubstrat entfernt ist, wird auch als Dünnfilm-Halbleiterchip bezeichnet.

Ein Dünnfilm-Halbleiterchip, etwa ein Dünnfilm-Leuchtdioden-Chip, kann sich weiterhin im Rahmen der vorliegenden Erfindung durch mindestens eines der folgenden charakteristischen Merkmale auszeichnen:
- an einer zu einem Trägerelement, z.B. dem Träger 27, hin gewandten ersten Hauptfläche eines Halbleiterkörpers, der eine Halbleiterschichtenfolge mit einem aktiven Bereich umfasst, insbesondere einer Epitaxieschichtenfolge, ist eine Spiegelschicht aufgebracht oder, etwa als Braggspiegel in der Halbleiterschichtenfolge integriert, ausgebildet, die zumindest einen Teil der in der Halbleiterschichtenfolge erzeugten Strahlung in diese zurückreflektiert;
- die Halbleiterschichtenfolge weist eine Dicke im Bereich von 20µm oder weniger, insbesondere im Bereich von 10 µm auf; und/oder
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, d.h. sie weist ein möglichst ergodisch stochastisches Streuverhalten auf.

Ein Grundprinzip eines Dünnfilm-Leuchtdiodenchips ist beispielsweise in I. Schnitzer et al., Appl. Phys. Lett. 63 (16), 18. Oktober 1993, 2174 - 2176 beschrieben.

Der Halbleiterkörper 21 weist einen aktiven Bereich 22 auf, der zwischen einem ersten Halbleiterbereich 23 und einem zweiten Halbleiterbereich 24 angeordnet ist. Der erste Halbleiterbereich 23 und der zweite Halbleiterbereich 24 weisen voneinander unterschiedliche Leitungstypen auf, sodass eine Diodenstruktur entsteht.

Der Halbleiterkörper 21 ist mittels einer Montageschicht 26 an dem Träger 27 befestigt. Für die Montageschicht eignet sich beispielsweise ein Lot oder ein Klebstoff.

Zwischen dem Halbleiterkörper 21 und dem Träger 27 ist eine Spiegelschicht 25 angeordnet, die dafür vorgesehen ist, im Betrieb im aktiven Bereich 22 erzeugte Strahlung in Richtung einer Strahlungsaustrittsfläche 20 des Halbleiterkörpers zu reflektieren.

Im Betrieb des Halbleiterchips 2 werden über einen ersten Kontakt 28 und einen zweiten Kontakt 29 Ladungsträger von verschiedenen Seiten in den aktiven Bereich 22 injiziert. Zwischen dem zweiten Kontakt 29 und dem Halbleiterkörper 21 ist eine Verteilungsschicht 29a ausgebildet. Die Verteilungsschicht ist für eine gleichmäßige Injektion von Ladungsträgern in den aktiven Bereich 22 vorgesehen. Die Verteilungsschicht 29a kann beispielsweise ein transparentes leitfähiges Oxid (transparent conductive oxide, TCO) enthalten oder aus einem solchen Material bestehen. Alternativ oder ergänzend kann die Verteilungsschicht 29a eine Metallschicht aufweisen, die so dünn ist, dass sie für die im aktiven Bereich 22 erzeugte Strahlung transparent oder zumindest transluzent ist. Bei hinreichend hoher elektrischer Querleitfähigkeit des ersten Halbleiterbereichs 23 kann auf die Verteilungsschicht 29a aber auch verzichtet werden.

Auf der Strahlungsaustrittsfläche 20 des Halbleiterkörpers 21 ist ein, vorzugsweise vorgefertigtes, Konversionsplättchen 7 ausgebildet, in das ein Konversionsstoff 71 zur Konversion der im aktiven Bereich 22 erzeugten Strahlung, eingebettet ist. Das Konversionsplättchen kann mittels einer Befestigungsschicht (nicht explizit dargestellt) an dem Halbleiterkörper 21 befestigt sein. Davon abweichend kann der Konversionsstoff 71 auch in die Umhüllung 5 eingebettet sein. Insbesondere bei direkter Ausnutzung der vom Halbleiterchip abgestrahlten Primärstrahlung kann auf einen Konversionsstoff auch vollständig verzichtet werden.

Weiterhin kann von dem beschriebenen Ausführungsbeispiel abweichend auch ein Halbleiterchip Anwendung finden, bei dem der Träger 27 durch das Aufwachssubstrat für die Halbleiterschichtenfolge des Halbleiterkörpers gebildet wird. Die Montageschicht 26 ist in diesem Fall nicht erforderlich. Weiterhin kann auch ein Halbleiterchip Anwendung finden, bei dem zumindest zwei Kontakte auf derselben Seite des Halbleiterchips angeordnet sind.

Alternativ oder ergänzend kann der Halbleiterchip auch als ein Strahlungsdetektor zum Empfangen von Strahlung ausgebildet sein.

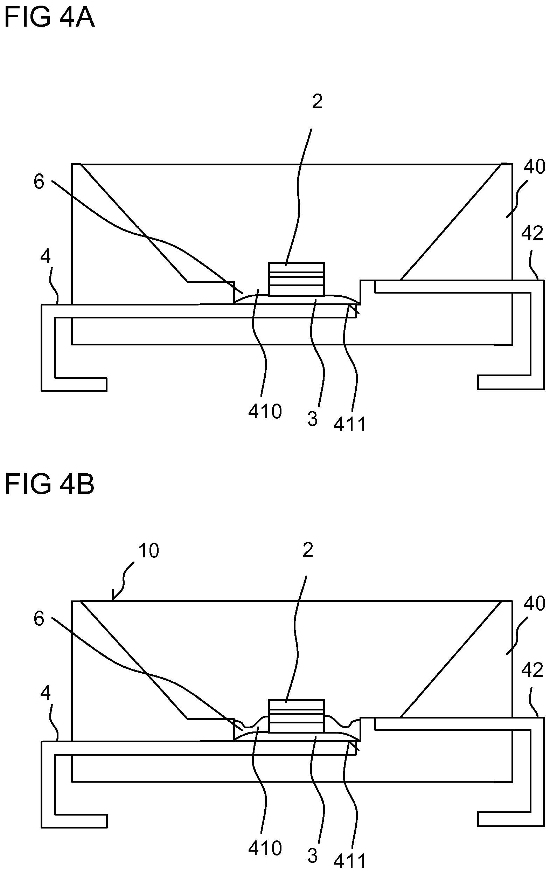

Ein Ausführungsbeispiel für ein Verfahren zur Herstellung eines Bauelements ist in den Figuren 4A bis 4C exemplarisch für die Herstellung eines Bauelements dargestellt, das wie im Zusammenhang mit Figur 1 beschrieben ausgeführt ist.

Ein Gehäusekörper 40 mit einem Anschlussträger 4 und einem weiteren Anschlussträger 42 wird bereitgestellt. Der Gehäusekörper 40 weist eine Kavität 410 auf, die für die Montage eines Halbleiterchips vorgesehen ist.

Der Halbleiterchip 2 wird mittels einer Verbindungsschicht 3, beispielsweise einer elektrisch leitfähigen Klebeschicht oder einer Lotschicht, an dem Anschlussträger 4 befestigt.

Wie in Figur 4B dargestellt, wird auf der Verbindungsschicht 3 in dem Bereich, der über den Halbleiterchip 2 in lateraler Richtung hinausragt, eine Entkopplungsschicht aufgebracht. Dies kann beispielsweise mittels eines Dispensers erfolgen. Alternativ kann beispielsweise Gießen, Spritzen, Spritzpressen oder Drucken Anwendung finden.

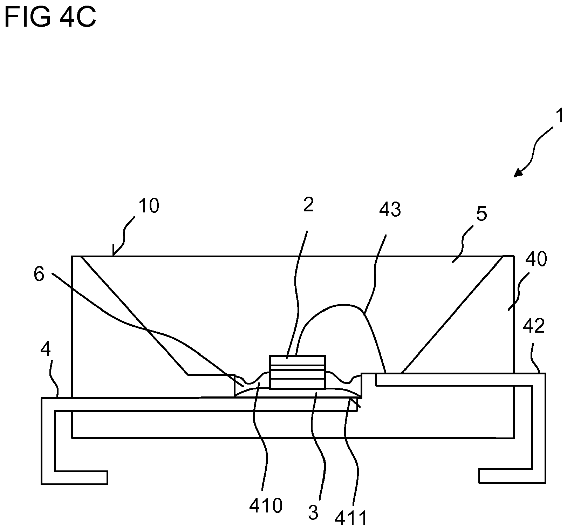

Zur Herstellung einer elektrisch leitenden Verbindung des Halbleiterchips 2 mit dem weiteren Anschlussträger 42 wird eine Bonddrahtverbindung als Verbindungsleitung 43 zwischen dem Halbleiterchip 2 und dem weiteren Anschlussträger ausgebildet (Figur 4C). Von dem beschriebenen Ausführungsbeispiel abweichend kann die Verbindungsleitung 43 aber auch ausgebildet werden, bevor die Entkopplungsschicht aufgebracht wird.

Zur Fertigstellung des Bauelements werden der Halbleiterchip 2 und die Verbindungsleitung 43 in eine Umhüllung 5 eingebettet. Hierbei ist die Umhüllung 5 mittels der Entkopplungsschicht 6 von der Verbindungsschicht 3 mechanisch entkoppelt. Die Gefahr, dass auftretende mechanische Spannungen ein Ablösen des Halbleiterchips 2 von dem Anschlussträger 40 verursachen, ist so weitgehend verringert. Die Lebensdauer und Zuverlässigkeit des Bauelements wird somit erhöht.

Mit dem beschriebenen Verfahren können Bauelemente hergestellt werden, die auch für den Fall einer Umhüllung mit einem vergleichsweise hohen Elastizitätsmodul, einer Umhüllung auf der Basis eines Epoxids, eine hohe Zuverlässigkeit und Lebensdauer aufweisen. Das Material für die Umhüllung 5 muss somit nicht primär hinsichtlich des Elastizitätsmoduls gewählt werden, sondern kann auf der Grundlage anderer chemischer und/oder physikalischer Eigenschaften, etwa optische Transparenz oder Alterungsstabilität, gewählt werden.

## Patentansprüche

1. Bauelement (1) mit einem optoelektronischen Halbleiterchip (2), der mit einer Verbindungsschicht (3) auf einem Anschlussträger (4) befestigt ist und in eine Umhüllung (5) eingebettet ist, wobei das Bauelement als ein oberflächenmontierbares Bauelement ausgeführt ist und einen Gehäusekörper (40) mit einer Kavität (410) aufweist, wobei der Halbleiterchip in der Kavität angeordnet ist; ein weiterer Anschlussträger der mittels einer Drahtbondverbindung (43) als elektrische Verbindungsleitung mit dem Halbleiterchip (2) verbunden ist und wobei die Drahtbondverbindung (43) auf die Umhüllung (5) beschränkt ist, **dadurch gekennzeichnet, dass**
- zwischen der Verbindungsschicht (3) und der Umhüllung (5) zumindest bereichsweise eine Entkopplungsschicht (6) angeordnet ist;
- die Entkopplungsschicht (6) einen Elastizitätsmodul von höchstens 1 GPa aufweist;
- die Entkopplungsschicht (6) einen geringeren Elastizitätsmodul aufweist als die Umhüllung (5);
- der Halbleiterchip (2) die Entkopplungsschicht in einer vertikalen Richtung überragt, sodass eine dem Anschlussträger (4) abgewandte Oberfläche des Halbleiterchips (2) frei von der Entkopplungsschicht (6) bleibt; und
- der Anschlussträger (4) und der weitere Anschlussträger (42) einen Leiterrahmen für das optoelektronische Bauelement (1) bilden und der Gehäusekörper (40) an den Leiterrahmen angeformt ist;
- die Entkopplungsschicht (6) unmittelbar an den Halbleiterchip (2) angrenzt und den Halbleiterchip (2) in lateraler Richtung umläuft;
- Seitenflächen des Halbleiterchips (2) nur teilweise von der Entkopplungsschicht (6) bedeckt sind und übrige Gebiete der Seitenflächen von der Umhüllung (5) direkt bedeckt sind;
- die Umhüllung (5) ein Epoxid mit einem Elastizitätsmodul von 2 GPa oder mehr enthält,
- die Entkopplungsschicht (6) ein Material enthält, dessen Glasübergangstemperatur T_{G} bei Raumtemperatur oder niedriger liegt, und
- die Entkopplungsschicht (6) für vom Halbleiterchip (2) im Betrieb emittierte Strahlung gezielt absorbierend ausgebildet ist.

2. Bauelement nach Anspruch 1,
wobei die Entkopplungsschicht einen Elastizitätsmodul von höchstens 200 kPa aufweist.

3. Bauelement nach Anspruch 1 oder 2,
wobei in die Entkopplungsschicht Partikel eingebettet sind.

4. Bauelement nach einem der vorhergehenden Ansprüche,
wobei die Entkopplungsschicht in Aufsicht auf das Bauelement einen über den Halbleiterchip hinausragenden Teil der Verbindungsschicht vollständig überdeckt.

5. Bauelement nach einem der vorhergehenden Ansprüche,
wobei eine Bodenfläche der Kavität vollständig von der Entkopplungsschicht bedeckt ist.

6. Verfahren zur Herstellung eines Bauelements (1) mit einem optoelektronischen Halbleiterchip (2) gemäß einem der vorherigen Ansprüche mit den Schritten:
- Bereitstellen eines Anschlussträgers (4);
- Befestigen des Halbleiterchips (2) mittels einer Verbindungsschicht (3) auf dem Anschlussträger (4);
- Aufbringen einer Entkopplungsschicht (6) auf die Verbindungsschicht (3), wobei die Entkopplungsschicht einen Elastizitätsmodul von höchstens 1 GPa aufweist und
der Halbleiterchip die Entkopplungsschicht in einer vertikalen Richtung überragt; und
- Aufbringen einer Umhüllung (5) auf die Entkopplungsschicht (6), wobei der Halbleiterchip (2) in die Umhüllung (5) eingebettet wird und die Entkopplungsschicht einen geringeren Elastizitätsmodul aufweist als die Umhüllung;
wobei das Bauelement als ein oberflächenmontierbares Bauelement ausgeführt ist und einen Gehäusekörper (40) mit einer Kavität (410) aufweist, wobei der Halbleiterchip in der Kavität angeordnet ist.

7. Verfahren nach dem vorhergehenden Anspruch,
wobei die Entkopplungsschicht mittels eines Dispensers hergestellt wird.

## Claims

1. A component (1) comprising an optoelectronic semiconductor chip (2) which is connected to a connecting layer (3) on a connection carrier (4) and which is embedded in a casing (5), wherein the component is configured as a surface-mountable component and comprises a housing body (40) having a cavity (410), wherein the semi-conductor chip is arranged in the cavity; a further connection carrier (42) which can be connected by means of a wire bond connection (43) is connected to the semiconductor chip (2) as an electrical connecting line, and wherein the wire bonding connection (43) is restricted to the casing (5),
**characterized in that**
- a decoupling layer (6) is arranged at least in regions between the connecting layer (3) and the casing (5);
- the decoupling layer (6) has a modulus of elasticity of at most 1 GPa;
- the decoupling layer (6) has a lower modulus of elasticity than the casing (5);
- the semiconductor chip (2) projects beyond the decoupling layer in a vertical direction such that a side of the semiconductor chip (2) remote from the connection carrier (4) remains free of the decoupling layer (6); and
- the connection carrier (4) and a further connection carrier (42) comprise a leadframe for the optoelectronic component (1) and the housing body (40) is formed onto the lead frame;
- the decoupling layer (6) directly adjoins the semiconductor chip (2) and surrounds the semiconductor chip (2) in the lateral direction;
- side surfaces of the semiconductor chip (2) are only partially covered by the decoupling layer (6) and remaining regions of the side surfaces are directly covered by the casing (5);
- the casing (5) contains an epoxide with a modulus of elasticity of 2 GPa or more,
- the decoupling layer (6) contains a material, the glass transition temperature T_{G} of which is at room temperature or lower, and
- the decoupling layer (6) is configured to be absorbing radiation emitted by the semiconductor chip (2) during operation.

2. The component according to claim 1,
wherein the decoupling layer has a modulus of elasticity of at most 200 kPa.

3. The component according to claim 1 or 2,
wherein particles are embedded in the decoupling layer.

4. The component according to one of the preceding claims, wherein in a plan view of the component, the decoupling layer completely covers a part of the connecting layer projecting beyond the semiconductor chip.

5. The component according to one of the preceding claims, wherein a bottom surface of the cavity is completely covered by the decoupling layer.

6. A method for producing a component (1) comprising an optoelectronic semiconductor chip (2) according to one of the preceding claims, comprising the steps of:
- providing a connection carrier (4);
- fixing the semiconductor chip (2) by means of a connecting layer (3) on the connection carrier (4);
- applying a decoupling layer (6) to the connecting layer (3), wherein the decoupling layer has a modulus of elasticity of at most 1 GPa and the semiconductor chip projects beyond the decoupling layer in a vertical direction; and
- applying a casing (5) to the decoupling layer (6), wherein the semiconductor chip (2) is embedded in the casing (5) and the decoupling layer has a lower modulus of elasticity than the casing;
wherein the component is configured as a surface-mountable component and has a housing body (40) having a cavity (410), wherein the semiconductor chip is arranged in the cavity.

7. The method according to the preceding claim,
wherein the decoupling layer is produced by means of a dispenser.

## Revendications

1. Composant (1) avec une puce semi-conductrice optoélectronique (2), qui est fixée avec une couche de liaison (3) sur un support de raccordement (4) et encastrée dans une armature (5), le composant étant présenté comme un élément montable sur une surface et présentant un corps de boîtier (40) avec une cavité (410), la puce semi-conductrice étant disposée dans la cavité ;
un autre support de raccordement qui est relié au moyen d'une connexion par fils (43) comme ligne de connexion électrique avec la puce semi-conductrice (2) et la connexion par fils (43) étant restreinte à l'armature (5),
**caractérisé en ce que**
- entre la couche de liaison (3) et l'armature (5), une couche de découplage (6) est apposée au moins par zone ;
- la couche de découplage (6) présente un module d'élasticité maximum de 1 GPa ;
- la couche de découplage (6) présente un module d'élasticité plus faible que l'armature (5) ;
- la puce semi-conductrice (2) dépasse la couche de découplage dans une direction verticale, de sorte qu'une surface de la puce semi-conductrice (2) détournée du support de raccordement (4) reste dégagée de la couche de découplage (6) ; et
- le support de raccordement (4) et l'autre support de raccordement (42) constituent un cadre à conducteurs pour le composant optoélectronique (1) et le corps de boîtier (40) formé sur le cadre à conducteurs jouxte la couche de découplage (6) directement sur la puce semi-conductrice (2) et contourne la puce semi-conductrice (2) dans une direction latérale ;
- des surfaces latérales de la puce semi-conductrice (2) sont couverts uniquement partiellement par la couche de découplage (6) et les autres régions des surfaces latérales sont couvertes directement par l'armature (5) ;
- l'armature (5) comprend un époxyde avec un module d'élasticité de 2 GPa ou plus ;
- la couche de découplage (6) contient une matière dont la température de transition vitreuse T_{G} est à température ambiante ou plus basse ; et
- la couche de découplage (6) est constituée de manière absorbante ciblée pour un rayonnement émis en fonctionnement par la puce semi-conductrice (2).

2. Composant selon la revendication 1,
la couche de découplage présentant un module d'élasticité maximum de 200 GPa.

3. Composant selon les revendications 1 ou 2,
des particules étant intégrées dans la couche de découplage.

4. Composant selon une quelconque des revendications précédentes,
la couche de découplage recouvrant complètement une partie dépassant au-dessus de la puce semi-conductrice en vue sur le composant.

5. Composant selon une quelconque des revendications précédentes,
une surface du fond de la cavité étant recouverte entièrement par la couche de découplage.

6. Procédé en vue de la fabrication d'un composant (1) avec une puce semi-conductrice optoélectronique (2) selon une quelconque des revendications précédentes avec les étapes de :
mise à disposition d'un support de raccordement (4) ;
fixation de la puce semi-conductrice optoélectronique (2), avec une couche de liaison (3) sur le support de raccordement (4) ;
application d'une couche de découplage (6) sur la couche de liaison (3), la couche de découplage présentant un module d'élasticité maximum de 1 GPa et la puce semi-conductrice dépassant la couche de découplage dans une direction verticale ; et
application d'une armature (5) sur la couche de découplage (6), la puce semi-conductrice (2) étant encastrée dans l'armature (5) et la couche de découplage présentant un module d'élasticité plus faible que l'armature ;
le composant étant présenté comme un élément montable sur une surface et présentant un corps de boîtier (40) avec une cavité (410) ,
la puce semi-conductrice étant disposée dans la cavité.

7. Procédé selon la revendication précédente,
la couche de découplage étant fabriquée au moyen d'un distributeur.
